# EUROPÄISCHE PATENTSCHRIFT

(11) **EP 2 964 979 B1**
(45) Veröffentlichungstag und Bekanntmachung des Hinweises auf die Patenterteilung: **19.09.2018**
(21) Anmeldenummer: 14723430.6
(22) Anmeldetag: 12.05.2014
(51) Int. Cl.: H05K 5/02, B60R 16/023, H01L 23/10, F16J 15/00

(54) **MEHRSTUFIGES DICHTSYSTEM ZUM EINSATZ IN EINEM KRAFTFAHRZEUGSTEUERGERÄT**
MULTI-STAGE SEALING SYSTEM FOR USE IN A MOTOR VEHICLE CONTROL UNIT
SYSTÈME D'ÉTANCHÉITÉ EN PLUSIEURS PARTIES DESTINÉ À ÊTRE UTILISÉ DANS UN APPAREIL DE COMMANDE DE VÉHICULE AUTOMOBILE

(30) Priorität: 01.08.2013 DE 102013215149
(43) Veröffentlichungstag der Anmeldung: 13.01.2016
(73) Patentinhaber: Conti Temic Microelectronic GmbH, 90411 Nürnberg (DE)
(72) Erfinder: HENNIGER, Jürgen, 91056 Erlangen-Dechsendorf (DE); WIECZOREK, Matthias, 91233 Neunkirchen am Sand (DE); REIF, Andreas, 90552 Röthenbach (DE); GEBHARDT, Marion, 91322 Gräfenberg (DE)
(74) Vertreter: Bonn, Roman Klemens
(86) Internationale Anmeldenummer: PCT/EP2014/059629
(87) Internationale Veröffentlichungsnummer: WO 2015/014509

(56) Entgegenhaltungen:
- WO-A1-2012/165647
- DE-A1- 2 150 092
- DE-A1-102006 049 592
- GB-A- 2 180 896
- US-A- 5 155 299
- US-A1- 2007 131 444

## Beschreibung

Die Erfindung betrifft ein Dichtsystem und eine Steuergerät nach dem Oberbegriff des Anspruchs 1 bzw. Anspruchs 8.

Im Kraftfahrzeugbau ist es seit längerer Zeit üblich, Steuergeräte für Motor oder Getriebe in die zu steuernde Kraftfahrzeugbaugruppe, also Motor oder Getriebe, zu integrieren. Vor allem die Getriebesteuergeräte bilden als so nannte Vorortsteuergerät eine äußerst kompakte Einheit. Im Vergleich zur konventionellen Verwendung externer Anbausteuergeräte hat diese Anordnung enorme Vorteile im Bezug auf Qualität, Kosten, Gewicht und Funktionalität. Insbesondere resultiert daraus eine erhebliche Verringerung von unter Umständen fehleranfälligen Steckverbindungen und Leitungen.

Ein ähnliches Dichtsystem ist aus WO 2012/165647 A1 bekannt. Die Integration des Steuergerätes in das Getriebe stellt hohe Anforderungen an seine thermische und mechanische Belastbarkeit. Die Funktionalität muss sowohl über einen breiten Temperaturbereich (etwa -40°C bis hin zu 200°C) als auch bei mechanischen Vibrationen (bis zu etwa 40g) gewährleistet sein. Das Gehäuse des Steuergeräts benötigt vor allem ein stabiles zuverlässiges Dichtsystem, das insbesondere eine hohe mechanische Festigkeit besitzt, gegen hohe Drücke und hohe Temperaturen und das gegen Schadstoffe wie Öl und schwefelhaltige Gase beständig ist.

Insbesondere können schwefelhaltige Schadgase durch Diffusion von außen durch die Dichtung in den Innenraum des Steuergerätegehäuses gelangen und zur Schädigung der elektronischen Funktionskomponenten wie Mikrokontroller oder auch von Bondpads oder Bonddrähten führen. Dies kann unter Umständen zum Totalausfall der Steuergeräte weit vor deren prognostizierter Lebenserwartung führen.

Kommen insbesondere metallhaltige Bauteile im Innenraum von Getriebesteuergeräten mit korrosiven Medien, wie schwefelhaltigen Gasen, Wasser oder feuchter Luft in Kontakt, so greifen diese das Metall an und es korrodiert.

Es ist daher eine Aufgabe der vorliegenden Erfindung, ein Dichtsystem für ein Gehäuse eines Kraftfahrzeugsteuergerätes der eingangs genannten Art derart weiterzubilden, dass die Dichtfunktion auf einfache Weise verbessert wird.

Diese Aufgabe ist erfindungsgemäß gelöst durch ein Dichtsystem mit den Merkmalen des Anspruchs 1

Erfindungsgemäß wurde erkannt, dass die Dichtfunktion eines ein erstes und ein mindestens weiteres Gehäuseteil umfassenden Gehäuses eines Kraftfahrzeugsteuergerätes dadurch verbessert wird, dass das Dichtsystem mehrstufig ausgeführt ist. Dabei weist mindestens ein Gehäuseteil mindestens eine Vorrichtung, beispielsweise eine Nut, zur Aufnahme mindestens eines Teils des mehrteiligen Dichtsystems auf, wobei insbesondere das erste Teil des Dichtsystems dafür geeignet ist, flüssige Schadstoffe wie Öl am Eindringen in das Innere das Gehäuses zu hindern.

Die weiteren Teile des Dichtsystems sind insbesondere dafür geeignet, gasförmige Schadstoffe, vor allem schwefelhaltige Gase vom Elektronikraum des Gehäuses fernzuhalten, um eine Schädigung insbesondere der elektronischen Funktionskomponenten wie Mikrokontroller zu verhindern.

Dabei ist ein Teil des Dichtsystems vorteilhafterweise als eine Feststoffdichtung, beispielsweise aus Kunststoff wie Elastomere, oder als ein Klebstoff, beispielsweise ein Zweikomponenten-Epoxidkleber ausgeführt. Ein weiterer Teil des Dichtsystems kann auch als katalytisch wirkende Komponente ausgeführt sein, das heißt schädliche Bestandteile aus der Umgebung selektiv in unschädliche Bestandteile umwandeln. Denkbar wäre auch ein Komponente mit rein filternder Eigenschaft. , Ein weiterer Teil des Dichtsystems kann auch als eine Getterschicht, beispielsweise aus einem Metall wie Aluminium, Kupfer, Silber, einer Silber-Palladium-Legierung oder Stahl, ausgeführt sein, um schädliche Bestandteile aus der Umgebung zu binden. Die Getterschicht kann auch ein Metallschaum wie z.B. gesintertes Material sein, um eine sehr große Oberfläche auf kleinem Volumen darzustellen.

Insbesondere die Feststoffdichtung als erste Dichtstufe zeichnet sich vor allem durch eine hohe Kohäsion, das heißt durch eine hohe innere Festigkeit aus, und ist dadurch besonders geeignet, bei hohen Drücken und auch hohen Temperaturen vor allem Öle am Eindringen in das Steuergerätinnere zu hindern.

Vor allem die Getterschicht zeichnet sich dagegen vor allem durch eine hohe Adhäsion an das Gehäusematerial, insbesondere an die Vorrichtung eines Gehäuseteils, das zur Aufnahme eines Teils des Dichtsystems vorgesehen ist, aus. Sie ist dadurch besonders geeignet, gasförmige Stoffe wie zum Beispiel schwefelhaltige Gase am Eindringen in das Steuergerätinnere zu hindern .

Aus Platzproblemen wäre auch eine Kombination der Teile des Dichtsystems denkbar. Beispielsweise könnte die Außenfläche einer Feststoffdichtung zusätzlich mit einem Klebstoff oder einer Getterschicht versehen sein.

Die Vorrichtungen zur Aufnahme eines Teils des Dichtsystems sind in der Regel in einem der Gehäuseteile angeordnet. Bei einem Gehäuse, das aus einem Gehäusedeckel und einem Gehäuseboden, der zum Beispiel als Grundplatte ausgeführt ist, besteht, ist eine derartige Vorrichtung beispielsweise als Nut in der Dichtfläche des Gehäusedeckels ausgebildet. Die Nut könnte aber auch im Gehäuse-boden angeordnet sein. Die verschiedenen Teile des Dichtsystems können in beliebiger Reihenfolge von innen nach außen in den entsprechenden Vorrichtungen angeordnet sein. So kann jedes Teil in einer separaten Vorrichtung angeordnet sein. Es kann aber auch vorkommen, dass mindestens zwei Teile des Dichtsystems, insbesondere bei engen Platzverhältnissen, in einer einzigen Vorrichtung angeordnet sind.

In der Regel wird es so sein, dass die erste, Öl hemmende Dichtung in Richtung Außenwand des Gehäuses, also in Richtung des umgebenden Öls, angebracht ist. Da diese Dichtung zwar speziell das Eindringen von Öl verhindern kann, aber normalerweise nicht geeignet ist, gasförmige Stoffe vollständig zu hemmen, muss eine weitere, dafür besonders geeignete Dichtung diese Funktion übernehmen, die wiederum nicht zwingend ölhemmend oder auch nicht einmal ölbeständig sein muss.

Durch dieses mehrstufige Dichtsystem wird vor allem erreicht, dass die an das Dichtsystem gestellten unterschiedliche Anforderungen auf unterschiedliche, in der Regel kostengünstige Teile mit unterschiedlichen, speziellen Eigenschaften verteilt werden, da es in der Regel nicht gelingt, alle an ein Dichtsystem eines Steuergerätes gestellten Anforderungen in einem einzigen, auch bezahlbaren Dichtbauteil zu realisieren.

Die Leiterstruktur, die aus dem Inneren des Gehäuses herausführt und ein elektronisches Bauteil im Inneren des Gehäuses mit Komponenten außerhalb des Gehäuses elektrisch leitend verbindet, kann je nach Anwendungsfall als ein flexibler Folienleiter oder kurz Flexfolienleiter, als starre Leiterplatte, als Stanzgitter oder als Kabel ausgebildet sein. Dabei sind jeweils an einem Endabschnitt der Leiterstruktur offene Kontaktbereiche angeordnet.

Insbesondere können ein oder mehrere elektronische Bauteile auf der Leiterstruktur oder auf einem separaten Schaltungsträger angeordnet sein. Im letzteren Fall werden die elektronischen Bauteile auf den Schaltungsträger mit dem offenen Kontaktbereichen der Leiterstruktur zum Beispiel mit Bonddrähten elektrisch verbunden.

Es wäre auch denkbar, dass die elektronischen Bauteile sowohl auf der Leiterstruktur als auch auf dem separaten Schaltungsträger angeordnet sind.

Eine weitere Aufgabe besteht darin, ein Steuergerät der eingangs genannten Art zu schaffen, das ein verbessertes Dichtsystem aufweist.
Die Merkmale des erfindungsgemäßen Steuergeräts im einzelnen und deren Vorteile entsprechen denen des oben beschriebenen erfindungsgemäßen Dichtsystems.

Weitere Merkmale, Vorteile und Einzelheiten der Erfindung sind der nachfolgenden Beschreibung entnehmbar, in der ein bevorzugtes Ausführungsbeispiel anhand der beigefügten Zeichnungen näher erläutert wird. Diese zeigen:
- Fig. 1: einen Schnitt durch ein Steuergerät, mit zwei Teilen des Dichtsystems in jeweils separaten Vorrichtungen,
- Fig. 2: einen Schnitt durch ein Steuergerät, mit zwei Teilen des Dichtsystems in einer einzigen Vorrichtung,
- Fig. 3: einen Schnitt durch ein Steuergerät, mit zwei von Fig. 1 verschiedenen Teilen des Dichtsystems in jeweils separaten Vorrichtungen, und
- Fig. 4: einen Schnitt durch ein Steuergerät, mit drei Teilen des Dichtsystems in jeweils separaten Vorrichtungen.

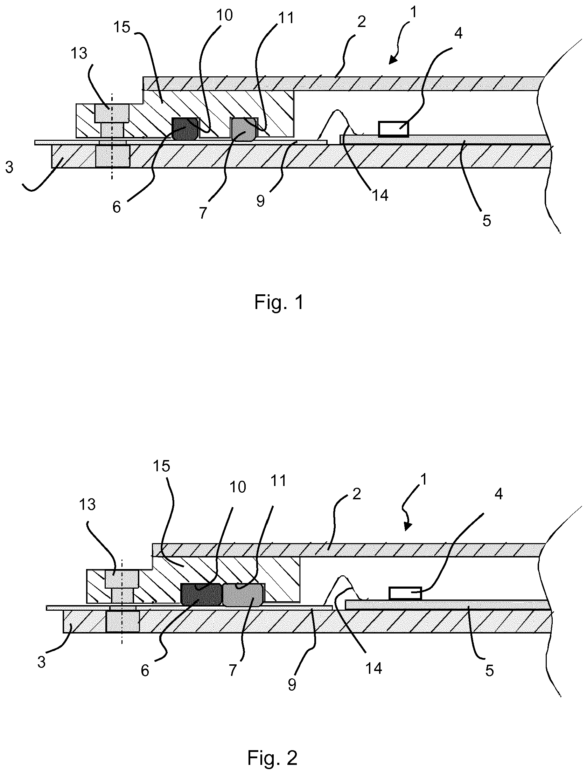

Fig. 1 zeigt ein Steuergerät mit einem Gehäuse 1, das ein als Deckel ausgebildetes erstes Gehäuseteil 2 und ein als Grund- oder Bodenplatte ausgebildetes zweites Gehäuseteil 3 umfasst. Zwischen dem ersten und dem zweiten Gehäuseteil ist hier ein als separate Aufnahme des Dichtsystems 6, 7, 8 ausgebildetes drittes Gehäuseteil 15 angeordnet. Diese separate Aufnahme könnte auch als integraler Teil entweder des ersten Gehäuseteils 2 oder auch des zweiten Gehäuseteils 3 ausgeführt sein. Die Aufnahme 15 weist Vorrichtungen 10, 11 zur Aufnahme von Teilen des Dichtsystems 6, 7, 8 auf. In diesem Fall sind das erste Teil 6 und das zweite Teil 7 in jeweils separaten, hier als Nut ausgeformte Vorrichtungen 10, 11 aufgenommen. Die Fixierung 13 der Gehäuseteile 1, 2, 15 zueinander ist insbesondere als Schraube oder als Niet ausgeführt.

Die erste, Öl hemmende Dichtung 6 des Dichtsystems ist in Richtung Außenwand des Gehäuses 1, also in Richtung des umgebenden Öls, angebracht. Diese Dichtung 6 ist speziell geeignet, das Eindringen von Öl in den Innenraum des Steuergerätes zu verhindern. Gasförmige Stoffe lässt diese Dichtung 6 in der Regel mindestens teilweise durch. Daher ist die weitere Dichtung 7 neben der ersten Dichtung 6 in Richtung Innenraum des Steuergerätes in der separaten Vorrichtung 11 angebracht. Die Reihenfolge der Anordnung der beiden Dichtungen 6, 7 könnte auch vertauscht sein.

Der erste Teil 6 des Dichtsystems ist insbesondere als eine Feststoffdichtung, beispielsweise aus Kunststoff wie Elastomere ausgebildet. Dieser erste Teil 6 zeichnet sich vor allem durch eine hohe Kohäsion, das heißt durch eine hohe innere Festigkeit aus, und ist dadurch besonders geeignet, auch bei extremen äußeren Bedingungen wie hohen Drücken und hohen Temperaturen vor allem Öle am Eindringen in das Steuergerätinnere zu hindern. Der erste Teil 6 des Dichtsystems kann auch als ein Klebstoff, beispielsweise ein Zweikomponenten-Epoxidkleber ausgeführt sein.

Ein weiterer Teil 7, 8 des Dichtsystems kann als eine Getterschicht, beispielsweise aus einem Metall wie Aluminium, Kupfer, Silber, einer Silber-Palladium-Legierung oder Stahl oder ebenfalls als ein Klebstoff, ausgeführt sein. Die weiteren Teile 7, 8 des Dichtsystems können aber auch als Filter oder Katalysator zum Filtern bzw. Umwandeln von schädlichen Bestandteilen aus der Umgebung ausgestaltet sein. Diese weiteren Teile 7, 8 zeichnen sich vor allem durch eine hohe Adhäsion insbesondere an das Gehäusematerial, hier an das Material der Vorrichtung 11 des dritten Gehäuseteils 15 aus. Sie sind dadurch besonders geeignet, gasförmige Stoffe wie zum Beispiel schwefelhaltige Gase am Passieren der Kontaktfläche zwischen Dichtung 7 und die Dichtung 7 umgebenden Teilen zu hindern, bzw. derart zu binden, um eine Beschädigung von elektronischen Funktionskomponenten im Gehäuseinnenraum zumindest für die Lebensdauer des Steuergeräts ausreichend zu verzögern.

Im Innenraum des Gehäuses 1 ist ein elektronisches Bauteil 4 auf einem Schaltungsträger 5 angeordnet. Es können auch mehrere, auch verschiedene elektronische Bauteile 4 wie zum Beispiel Prozessoren, Transistoren oder passive Bauteile auf den Schaltungsträger 5 aufgebracht sein. Der Schaltungsträger 5 kann zum Beispiel eine herkömmliche PCB oder ein Keramikschaltungsträger sein.

Die elektrisch leitende Verbindung zwischen dem oder den Bauteilen 4 im Inneren des Gehäuses 1 und Komponenten außerhalb des Gehäuses 1 wird durch eine Leiterstruktur 9 hergestellt. Diese Leiterstruktur 9 kann je nach Anwendungsfall als ein flexibler Folienleiter, als starre Leiterplatte, als Stanzgitter oder als Kabel ausgeführt sein. Dabei sind jeweils an einem Endabschnitt der Leiterstruktur 9 in nicht gezeigter Weise offene Kontaktbereiche angeordnet. Im Falle einer flexiblen Leiterplatte als Leiterstruktur 9 ist diese in der Regel auf die Grundplatte 3 aufgeklebt oder auflaminiert.

Die elektrisch leitende Verbindung zwischen den elektrischen Komponenten 4 und den offenen Kontaktbereichen der Leiterstruktur 9 ist hier mittels eines Bonddrahtes 14 hergestellt.

Es sind auch Steuergeräteausführungen denkbar, bei denen auf einen Schaltungsträger 5 verzichtet werden kann. Dann sind die elektronischen Bauteile 4 direkt auf der Leiterstruktur 9 aufgebracht.

Fig. 2 zeigt ein Steuergerät, wobei die Vorrichtungen 10 und 11 zu einer einzigen Vorrichtung zur Aufnahme der Dichtungen 6 und 7 zusammengefasst sind. Auch hier ist insbesondere die Reihenfolge in der Anordnung der Dichtungen 6 und 7 beliebig.

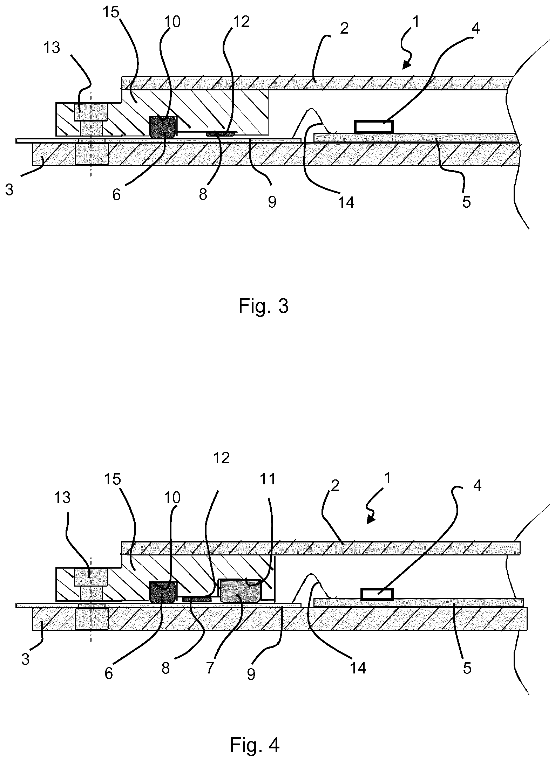

Fig. 3 zeigt ein Steuergerät mit zwei Teilen 6, 8 des Dichtsystems, bei dem wie in der Ausführungsform aus Fig. 1 die beiden Teile 6, 8 in jeweils separaten, als Nut ausgeformte Vorrichtungen 10, 12 aufgenommen sind. Im Gegensatz zu Fig. 1 ist hier die zweite, gashemmende Dichtung 8 als dünne Getterschicht oder Schicht aus Klebstoff ausgeführt. Die Reihenfolge in der Anordnung der Dichtungen 6 und 8 ist in der Regel auch hier beliebig. Aus Platzproblemen wäre auch eine Kombination der Teile 6 und 8 des Dichtsystems denkbar. Beispielsweise könnte die Außenfläche der Dichtung 6 zusätzlich mit einem Klebstoff oder einer Getterschicht versehen sein. Diese Ausführungsform ist nicht gezeigt.

Fig. 4 zeigt ein Steuergerät mit drei Teilen 6, 7, 8 des Dichtsystems, bei dem wie in der Ausführungsform aus Fig. 1 und 3 die Teile 6, 7, 8 in jeweils separaten, als Nut ausgeformte Vorrichtungen 10, 11, 12 aufgenommen sind. Die Reihenfolge in der Anordnung der Dichtungen 6, 7 und 8 ist in der Regel auch hier beliebig.

Durch dieses mehrstufige Dichtsystem wird insbesondere erreicht, dass die an das Dichtsystem eines Gehäuses, insbesondere eines Gehäuses für ein Kraftfahrzeuggetriebesteuergerät gestellten unterschiedlichen Anforderungen auf unterschiedliche Teile mit unterschiedlichen, speziellen Eigenschaften verteilt werden. Diese einzelnen Teile des Dichtsystems sind in der Regel kostengünstiger in der Herstellung, als ein einziges Dichtbauteil, das alle Anforderungen erfüllen muss.

### Bezugszeichenliste:

- 1: Gehäuse
- 2: Erstes Gehäuseteil
- 3: Zweites Gehäuseteil
- 4: Elektronisches Bauteil
- 5: Schaltungsträger
- 6: Erstes Teil des Dichtsystems
- 7, 8: Weitere Teile des Dichtsystems
- 9: Leiterstruktur
- 10, 11, 12: Vorrichtung zur Aufnahme des Dichtsystems
- 13: Fixierung des ersten zum zweiten Gehäuseteil
- 14: Elektrisch leitende Verbindungsleitung, Bonddraht
- 15: Separate Aufnahme des Dichtsystems, drittes Gehäuseteil

## Patentansprüche

1. Mehrteiliges Dichtsystem (6, 7, 8) für ein Gehäuse (1) eines Kraftfahrzeugsteuergerätes aus einem ersten Gehäuseteil (2) und mindestens einem weiteren Gehäuseteil (3, 15), mit
- mindestens einem elektronischen Bauteil (4) im Inneren des Gehäuses (1), und
- mindestens einer Leiterstruktur (9), die zwischen den Gehäuseteilen (2, 3) aus dem Inneren des Gehäuses (1) herausführt und ein elektronisches Bauteil (4) im Inneren des Gehäuses (1) mit Komponenten außerhalb des Gehäuses (1) elektrisch leitend verbindet,
**dadurch gekennzeichnet, dass**
mindestens ein Gehäuseteil (2, 3, 15) mindestens eine Vorrichtung (10, 11, 12) zur Aufnahme mindestens eines Teils des mehrteiligen Dichtsystems (6, 7, 8) aufweist, und dass das erste Teil (6) des Dichtsystems als Klebstoff oder als eine Feststoffdichtung ausgebildet ist und in Richtung Außenwand des Gehäuses (1) angebracht ist, und speziell dafür geeignet ist, flüssige Schadstoffe am Eindringen in das Innere des Gehäuses (1) zu hindern, und die weiteren Teile (7, 8) des Dichtsystems als ein Katalysator, ein Filter oder als eine Getterschicht ausgebildet sind, und in Richtung Innenraum des Gehäuses (1) angebracht sind, und speziell dafür geeignet sind, gasförmige Schadstoffe am Eindringen in das Innere des Gehäuses (1) zu hindern.

2. Mehrteiliges Dichtsystem (6, 7, 8) nach Anspruch 1, **dadurch gekennzeichnet, dass**
die Getterschicht aus einem Metall wie Aluminium, Kupfer, Silber, einer Silber-Palladium-Legierung oder Stahl ist.

3. Mehrteiliges Dichtsystem (6, 7, 8) nach einem der Ansprüche 1 oder 2 3 , **dadurch gekennzeichnet, dass**
die Getterschicht auf einem Teil (6, 7, 8) des Dichtsystems aufgebracht ist.

4. Mehrteiliges Dichtsystem (6, 7, 8) nach einem der Ansprüche 1 bis 3 , **dadurch gekennzeichnet, dass**
die verschiedenen Teile (6, 7, 8) des Dichtsystems jeweils in separaten Vorrichtungen (10, 11,12) des Gehäuses (1) angeordnet sind.

5. Mehrteiliges Dichtsystem (6, 7, 8) nach einem der Ansprüche 1 bis 5, **dadurch gekennzeichnet, dass**
mindestens zwei Teile (6, 7, 8) des Dichtsystems in einer einzigen Vorrichtung (10, 11,12) des Gehäuses (1) angeordnet sind.

6. Mehrteiliges Dichtsystem (6, 7, 8) nach einem der vorangehenden Ansprüche , **dadurch gekennzeichnet, dass**
die Leiterstruktur (9) als Flexfolienleiter, als starre Leiterplatte, als Stanzgitter oder als Kabel mit jeweils an einem Endabschnitt angeordneten offenen Kontaktbereichen ausgebildet ist.

7. Mehrteiliges Dichtsystem (6, 7, 8) nach einem der vorangehenden Ansprüche, **dadurch gekennzeichnet, dass** das elektronische Bauteil (4) auf der Leiterstruktur (9) und/ oder einem separaten Schaltungsträger (5) angeordnet ist

8. Steuergerät, insbesondere für ein Kraftfahrzeug, mit einem Gehäuse (1) aus einem ersten Gehäuseteil (2) und mindestens einem weiteren Gehäuseteil (3, 15), mit
- mindestens einem elektronischen Bauteil (4) im Inneren des Gehäuses (1),
- mindestens einer Leiterstruktur (9), die aus dem Inneren des Gehäuses (1) herausführt und den Schaltungsträger (5) bzw. ein elektronisches Bauteil (4) im Inneren des Gehäuses (1) mit Komponenten außerhalb des Gehäuses (1) elektrisch leitend verbindet, und
- einem mehrteiligen Dichtsystem (6, 7, 8) zwischen den Gehäuseteilen (2, 3, 15),
**dadurch gekennzeichnet, dass**
mindestens ein Gehäuseteil (2, 3, 15) mindestens eine Vorrichtung (10, 11, 12) zur Aufnahme mindestens eines Teils des mehrteiligen Dichtsystems (6, 7, 8) aufweist, und dass das erste Teil (6) des Dichtsystems als Klebstoff oder als eine Feststoffdichtung ausgebildet ist und in Richtung Außenwand des Gehäuses (1) angebracht ist und speziell dafür geeignet ist, flüssige Schadstoffe am Eindringen in das Innere des Gehäuses (1) zu hindern, und die weiteren Teile (7, 8) des Dichtsystems als ein Katalysator, ein Filter oder als eine Getterschicht ausgebildet sind und in Richtung Innenraum des Gehäuses (1) angebracht sind, und speziell dafür geeignet sind, gasförmige Schadstoffe am Eindringen in das Innere des Gehäuses (1) zu hindern.

## Claims

1. Multi-part sealing system (6, 7, 8) for a housing (1) of a motor vehicle control unit, said housing (1) being composed of a first housing part (2) and at least one further housing part (3, 15), having
- at least one electronic component (4) in the interior of the housing (1), and
- at least one conductor structure (9) which leads out of the interior of the housing (1) between the housing parts (2, 3) and connects an electronic component (4) in the interior of the housing (1) to components outside the housing (1) in an electrically conductive fashion,
**characterized in that**
at least one housing part (2, 3, 15) has at least one device (10, 11, 12) for accommodating at least part of Multi-part sealing system (6, 7, 8) and **in that** the first part (6) of the sealing system is embodied as an adhesive or as a solid seal and is attached in the direction of the outer wall of the housing (1), and is specifically suitable for preventing liquid noxious substances from penetrating into the interior of the housing (1), and the further parts (7, 8) of the sealing system are embodied as a catalytic converter, a filter or as a getter layer and are attached in the direction of the interior of the housing (1), and are specifically suitable for preventing gaseous noxious substances from penetrating into the interior of the housing (1).

2. Multi-part sealing system (6, 7, 8) according to Claim 1, **characterized in that**
the getter layer is composed of a metal such as aluminum, copper, silver, a silver-palladium alloy or steel.

3. Multi-part sealing system (6, 7, 8) according to one of Claims 1 or 2 3, **characterized in that**
the getter layer is applied to a part (6, 7, 8) of the sealing system.

4. Multi-part sealing system (6, 7, 8) according to one of Claims 1 to 3, **characterized in that**
the various parts (6, 7, 8) of the sealing system are each arranged in separate devices (10, 11, 12) of the housing (1) .

5. Multi-part sealing system (6, 7, 8) according to one of Claims 1 to 4, **characterized in that**
at least two parts (6, 7, 8) of the sealing system are arranged in a single device (10, 11, 12) of the housing (1) .

6. Multi-part sealing system (6, 7, 8) according to one of the preceding claims, **characterized in that**
the conductor structure (9) is embodied as a flex film conductor, as a rigid conductor circuit board, as a cut matrix or as a cable with open contact regions which are arranged in each case at an end section.

7. Multi-part sealing system (6, 7, 8) according to one of the preceding claims, **characterized in that** the electronic component (4) is arranged on the conductor structure (9) and/or a separate circuit carrier (5).

8. Control unit, in particular for a motor vehicle, having a housing (1) composed of a first housing part (2) and at least one further housing part (3, 15), having
- at least one electronic component (4) in the interior of the housing (1),
- at least one conductor structure (9) which leads out of the interior of the housing (1) and connects the circuit carrier (5) or an electronic component (4) in the interior of the housing (1) to components outside the housing (1) in an electrically conductive fashion, and
- a multi-part sealing system (6, 7, 8) between the housing parts (2, 3, 15),
**characterized in that**
at least one housing part (2, 3, 15) has at least one device (10, 11, 12) for accommodating at least part of Multi-part sealing system (6, 7, 8), and **in that** the first part (6) of the sealing system is embodied as an adhesive or as a solid seal and is attached in the direction of the outer wall of the housing (1), and is specifically suitable for preventing liquid noxious substances from penetrating into the interior of the housing (1), and the further parts (7, 8) of the sealing system are embodied as a catalytic converter, a filter or as a getter layer and are attached in the direction of the interior of the housing (1), and are specifically suitable for preventing gaseous noxious substances from penetrating into the interior of the housing (1).

## Revendications

1. Système d'étanchéité en plusieurs parties (6, 7, 8) pour un boîtier (1) d'un appareil de commande de véhicule automobile en une première partie de boîtier (2) et au moins une autre partie de boîtier (3, 15), avec
- au moins un composant électronique (4) à l'intérieur du boîtier (1), et
- au moins une structure de conducteur (9), qui conduit entre les parties de boîtier (2, 3) hors de l'intérieur du boîtier (1) et relie de façon électriquement conductrice un composant électronique (4) à l'intérieur du boîtier (1) à des composants situés à l'extérieur du boîtier (1),
**caractérisé en ce qu'**au moins une partie de boîtier (2, 3, 15) présente au moins un dispositif (10, 11, 12) destiné à contenir au moins une partie du système d'étanchéité en plusieurs parties (6, 7, 8), et **en ce que** la première partie (6) du système d'étanchéité est formée par une colle ou par un joint solide et est placée en direction de la paroi extérieure du boîtier (1), et convient spécialement pour empêcher des polluants liquides de pénétrer dans l'intérieur du boîtier (1), et les autres parties (7, 8) du système d'étanchéité sont formées par un catalyseur, un filtre ou une couche de piégeage et sont placées en direction de l'espace intérieur du boîtier (1), et conviennent spécialement pour empêcher des polluants gazeux de pénétrer dans l'intérieur du boîtier (1).

2. Système d'étanchéité en plusieurs parties (6, 7, 8) selon la revendication 1, **caractérisé en ce que** la couche de piégeage est réalisée en un métal comme l'aluminium, le cuivre, l'argent, un alliage argent-palladium ou un acier.

3. Système d'étanchéité en plusieurs parties (6, 7, 8) selon une des revendications 1 ou 2, **caractérisé en ce que** la couche de piégeage est déposée sur une partie (6, 7, 8) du système d'étanchéité.

4. Système d'étanchéité en plusieurs parties (6, 7, 8) selon l'une quelconque des revendications 1 à 3, **caractérisé en ce que** les différentes parties (6, 7, 8) du système d'étanchéité sont respectivement disposées dans des dispositifs distincts (10, 11, 12) du boîtier (1).

5. Système d'étanchéité en plusieurs parties (6, 7, 8) selon l'une quelconque des revendications 1 à 5, **caractérisé en ce qu'**au moins deux parties (6, 7, 8) du système d'étanchéité sont disposées dans un seul dispositif (10, 11, 12) du boîtier (1).

6. Système d'étanchéité en plusieurs parties (6, 7, 8) selon l'une quelconque des revendications précédentes, **caractérisé en ce que** la structure de conducteur (9) est réalisée sous la forme de conducteur en film flexible, de plaquette rigide de circuits imprimés, de grille estampée ou de câble, avec des zones de contact ouvertes disposées respectivement à une partie d'extrémité.

7. Système d'étanchéité en plusieurs parties (6, 7, 8) selon l'une quelconque des revendications précédentes, **caractérisé en ce que** le composant électronique (4) est disposé sur la structure de conducteur (9) et/ou sur un support de circuit séparé (5).

8. Appareil de commande, en particulier pour un véhicule automobile, avec un boîtier (1) en une première partie de boîtier (2) et au moins une autre partie de boîtier (3, 15), avec
- au moins un composant électronique (4) à l'intérieur du boîtier (1),
- au moins une structure de conducteur (9), qui conduit hors de l'intérieur du boîtier (1) et relie de façon électriquement conductrice le support de circuit (5) ou un composant électronique (4) à l'intérieur du boîtier (1) à des composants situés à l'extérieur du boîtier (1), et
- un système d'étanchéité en plusieurs parties (6, 7, 8) entre les parties de boîtier (2, 3, 15),
**caractérisé en ce qu'**au moins une partie de boîtier (2, 3, 15) présente au moins un dispositif (10, 11, 12) destiné à contenir au moins une partie du système d'étanchéité en plusieurs parties (6, 7, 8), et **en ce que** la première partie (6) du système d'étanchéité est formée par une colle ou par un joint solide et est placée en direction de la paroi extérieure du boîtier (1), et convient spécialement pour empêcher des polluants liquides de pénétrer dans l'intérieur du boîtier (1), et les autres parties (7, 8) du système d'étanchéité sont formées par un catalyseur, un filtre ou une couche de piégeage et sont placées en direction de l'espace intérieur du boîtier (1), et conviennent spécialement pour empêcher des polluants gazeux de pénétrer dans l'intérieur du boîtier (1).
